(19) Europäisches Patentamt
European Patent Office
Office européen des brevets

(11) **EP 4 456 155 A1**

## (12) EUROPEAN PATENT APPLICATION

(43) Date of publication:
**30.10.2024 Bulletin 2024/44**

(21) Application number: **23315119.0**

(22) Date of filing: **27.04.2023**

(51) International Patent Classification (IPC):
***H01L 31/108*** (2006.01)

(52) Cooperative Patent Classification (CPC):
**H01L 31/1085; H01L 31/108**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
- **Almae Technologies
91460 Marcoussis (FR)**
- **Centre National de la Recherche Scientifique
75016 Paris (FR)**

- **Université Paris-Saclay
91190 Gif-sur-Yvette (FR)**

(72) Inventors:
- **Deeb, Claire
91120 Palaiseau (FR)**
- **Pelouard, Jean-Luc
75011 Paris (FR)**
- **Pardo, Fabrice
94400 Vitry-sur-Seine (FR)**

(74) Representative: **Osha BWB
2, rue de la Paix
75002 Paris (FR)**

## (54) ASYMMETRIC METAL-SEMICONDUCTOR-METAL PHOTODETECTORS

(57) The present disclosure relates to a photodetector configured to detect incident light in a given range of wavelengths comprising: an absorbing semiconductor layer (325); a first semiconductor layer (321) made of a first semiconductor material and in electrical contact with said absorbing semiconductor layer; a first metal electrode (340) in electrical contact with the first semiconductor layer (321), configured to produce with the first semiconductor layer (321), an electron Schottky junction, wherein the first semiconductor layer is arranged between said first metal electrode and the absorbing semiconductor layer; a second semiconductor layer (322) made of a second semiconductor material different from the first semiconductor material, in electrical contact with said absorbing semiconductor layer; a second metal electrode (330) in electrical contact with the second semiconductor layer configured to produce with the second semiconductor layer, a hole Schottky junction, wherein the second semiconductor layer is arranged between said second metal electrode and the absorbing semiconductor layer.

FIG.3A

**Description**

TECHNICAL FIELD OF THE INVENTION

The present description relates to asymmetric metal-semiconductor-metal photodetectors. Further, the present description relates to methods for fabricating such photodetectors.

BACKGROUND OF THE INVENTION

Metal-semiconductor-metal (MSM) photodetectors are generally known as high-speed photodetectors and have valuable applications, notably in optical communication systems, such as for example fiber-optic networks.

Generally speaking, a photodetector's effectiveness is measured by its performance in many different parameters. These parameters include spectral range of the response, speed, responsivity (or sensitivity), and dark current density. The speed of a photodetector is the time required for the device to increase its photocurrent to the steady state value when the incident light is switched on and to decrease it when the light is switched off. The sensitivity, also referred to as responsivity or external quantum efficiency of a photodetector, is a measure of how much incident light on the photodetector is collected and outputted as an external current density. It is defined by the ratio of the photocurrent divided by the total incident light power. Dark current density is generically defined as a current density that flows in photodetectors when there is no radiant flux (light source) incident upon the photodetector.

The constant increase in the speed of optical telecommunications requires ever faster and more sensitive photodetectors. Increasing the intrinsic speed of the photodetectors makes it possible to increase the information rate without modifying either the communication protocol or the architecture of the network. On the other hand, increasing the sensitivity of the photodetectors makes it possible to moderate the increase in the power consumption when the data flow increases. In addition, having very fast and sensitive photodetectors could enable substituting electrical connections that are currently used for very short-range communications with optical connections, for example among chips on a same printed circuit board to reduce their power consumption.

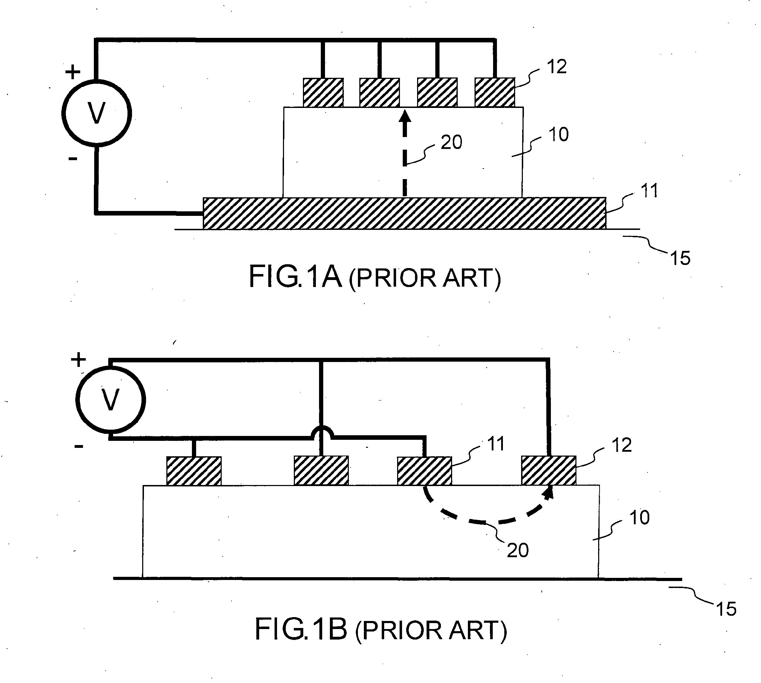

Conventional MSM photodetectors of the prior art are illustrated in Figs. 1A and 1B and described for example in Shi et al. [Ref. 1].

MSM photodetectors are flat (planar) structures with several layers arranged on a substrate 15, comprising a semiconductor layer 10 and first and second metal electrodes 11, 12.

The semiconductor layer 10 has a bandgap small enough to absorb incident light in an operating spectral range, thereby exciting for each absorbed photon an electron from the valence band to the conduction band. A pair of free carriers is thus created: an electron in the conduction band and a hole in the valence band. The free carriers are driven by a local static electric field towards the electrodes where they are collected to contribute to the external current. For applications in optical communication systems wherein operating wavelengths are for example around 1.3 $\mu$m or around 1.5 $\mu$m, low bandgap semiconductor materials such as germanium, III - V compounds or II - VI compounds are adapted since their bandgap is smaller than the energy of the incident photons, i.e., 0.95 eV and 0.82 eV respectively.

As shown in Figs. 1A and 1B, first and second metal electrodes 11, 12 are deposited on either side of the semiconductor layer ("vertical arrangement", Fig. 1A) or onto the semiconductor layer ("horizontal arrangement", Fig. 1B). The electrodes can be structured (as illustrated in Fig. 1A and Fig. 1B) to improve the optical coupling of the device with the incoming light. A bias voltage V is applied between the first electrode 11 (e.g., the cathode) and the second electrode 12 (e.g., the anode).

In MSM photodetectors, the metal electrodes together with the semiconductor layer are configured to form Schottky junctions. A Schottky junction, also referred to as Schottky barrier or Schottky contact in the present description, is a potential barrier for electrons or for holes, formed at a metal-semiconductor interface. Schottky barriers have rectifying characteristics, suitable for use as a diode. Therefore, in a Schottky junction, for a positive bias voltage, the current increases exponentially with the voltage, while for a negative bias voltage, the current is almost constant with the voltage, provided the bias voltage is larger than a few $k_B T$ (thermal energy), where $k_B$ is the Boltzmann's constant and T is the temperature. In the horizontal arrangement as shown in Fig. 1B, both electrodes (anode and cathode) are on the same semiconductor layer. They are "interdigitated"; thus, the bias voltage V is applied between two adjacent Schottky junctions.

One of the primary characteristics of a Schottky junction is the height of the potential barrier. For an electron Schottky junction in which the current under a high enough reverse bias voltage (i.e. at least a few $k_B T$) is dominated by the flux of electrons across the junction, the potential barrier height is the height of the potential barrier seen by the electron injected in the semiconductor layer, noted $\varphi_e$ and referred to as the "electron Schottky barrier height" in the present description. For a hole Schottky junction in which the current under a high enough reverse bias voltage (i.e. at least a few $k_B T$) is dominated by the flux of holes across the junction, the potential barrier height is the height of the potential barrier seen by the holes injected in the semiconductor layer, noted $\varphi_h$ and referred to as the "hole Schottky barrier height" in the present description. The values of the Schottky barrier heights $\varphi_e$ and ($\varphi_h$ depend on the combination of the metal and the semiconductor at the interface.

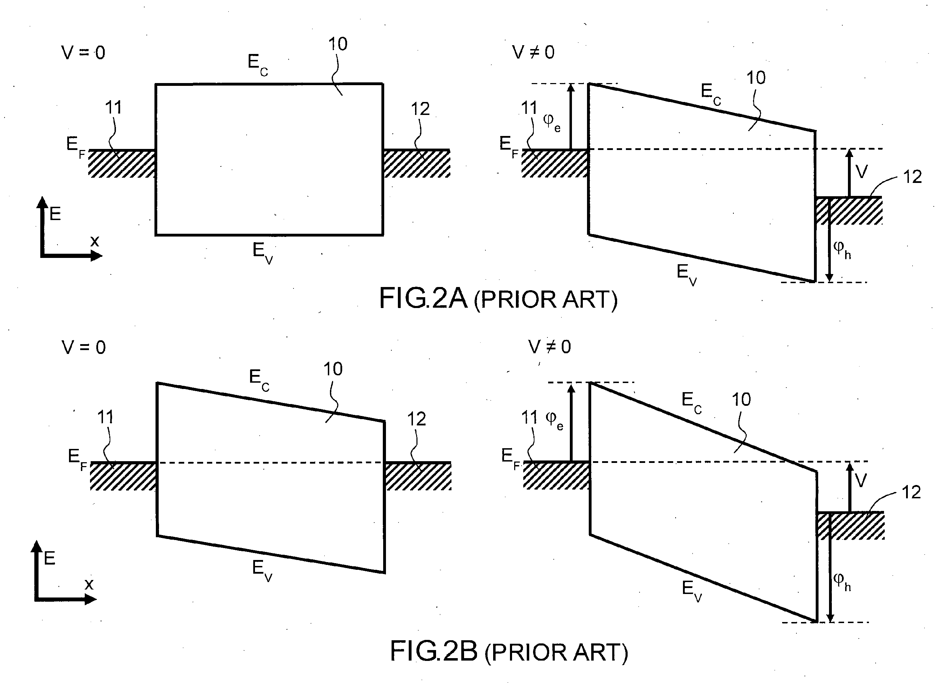

Fig. 2A illustrates a theoretical band diagram of a MSM photodetector of the prior art, using the same metal for both electrodes, as described for example in Ito et al. [Ref. 2]. For graphic convention of the band diagrams, see for example Darling et al. [Ref. 3]. Fig. 2B illustrates a band diagram of a MSM photodetector of the prior art, using different metals for both electrodes, as described for example in Fresser et al. [Ref. 4] and US 5,780,916 [Ref. 5].

The band diagram schematically represents, in a 1D approximation, the energy level (E-axis) along an arbitrary chosen line (x-axis) of constant static current density between the two electrodes. Such arbitrary chosen line of constant static current density between the two electrodes is illustrated by the dashed line 20 in Fig. 1A and Fig. 1B. $E_F$ illustrates the Fermi level in the metal parts, $E_C$ illustrates the minimum energy of the semiconductor conduction band and $E_V$ illustrates the maximum energy of the semiconductor valence band.

For both embodiments of FIG. 2A and FIG. 2B, the band diagrams are shown for a bias voltage applied between the electrodes V=0 (left) and V≠0 (right).

In the example of Fig. 2A, electrodes 11, 12 (respectively the cathode and the anode in this example) are made with the same metal deposited on the semiconductor layer; at V=0 the Fermi level ($E_F$) of the metal is located at the same energy level (along the E-axis) at both metal-semiconductor interfaces. As a result of having the same metal deposited on the semiconductor layer, under a given bias voltage V≠0, the potential barrier seen by the electrons injected in the semiconductor layer (electron Schottky barrier height $\varphi_e$) and the potential barrier seen by the holes injected in the semiconductor layer (hole Schottky barrier ($\varphi_h$) are the same at both electrodes.

In MSM photodetectors, the dark current density $I_{dark}$ at a given bias voltage V≠0 is equal to the sum of the current density of electrons $I_e$ injected into the semiconductor by the Schottky junction whose metal part is subject to a negative potential and the current density of holes $I_h$ injected into the semiconductor by the Schottky junction whose metal part is subject to a positive potential. Each of these current densities is controlled by the Schottky barrier via different possible mechanisms: tunnel current, field-assisted tunnel current, thermionic current.

At moderate reverse bias voltage (i.e. slightly larger than a few $k_BT$), these current densities can be written in a good approximation as:

$$I_e = I_{0e} \exp[-\varphi_e/k_BT] \text{ with } I_{0e} = A^*_e T^2 [\exp(qV/k_BT) - 1]$$

$$I_h = I_{0h} \exp[-\varphi_h/k_BT] \text{ with } I_{0e} = A^*_h T^2 [\exp(qV/k_BT) - 1]$$

Where $A^*_e$ (resp. $A^*_h$) is the effective Richardson's constant for electron (resp. hole) emission [Ref. 3].

$I_e$ and $I_h$ are therefore very sensitive to the barrier heights since $k_BT$ is about 25meV at room temperature. An objective is to make the dark current density $I_{dark}$ of the detector very low by choosing the Schottky contacts that are fabricated on the semiconductor layer.

However, in such MSM photodetectors employing Schottky contacts using the same metal, the Schottky barrier heights (hole and electron) are restricted by the bandgap of the semiconductor. Indeed, the sum of the two barrier heights $\varphi_e + \varphi_h$ is equal to the bandgap $E_G$ of the semiconductor. Therefore, a modification (for example by changing the nature of the metal) of the height of the potential barrier $\varphi_e$ seen for example by the electrons will result in the equal and opposite modification of the height of the potential barrier $\varphi_h$ seen by the holes. Consequently, $I_e$ is a decreasing function of $\varphi_e$ and $I_h$ an increasing function of $\varphi_e$. Therefore, the sum of these two current densities has a minimum corresponding to a best optimization of the photodetector.

As an example, the applicant has determined that the dark current density of MSM photodetectors using Au/Ti/InP (gold/titanium/indium phosphide) as Schottky contacts cannot be less than 129 fA.$\mu$m$^{-2}$. In practice, it is difficult to define the conditions (nature of the metal, treatment of the surface of the semiconductor, etc.) for manufacturing Schottky contacts corresponding to such a minimum. Such minimum can at best be approached, which will lead to an increase in the dark current density compared to the absolute minimum defined above.

In the example of Fig. 2B, a different metal is used for each electrode.

In such embodiment, one metal electrode can be chosen to have a high electron Schottky barrier height ($\varphi_e$), and the other electrode can be chosen to have a high hole Schottky barrier height ($\varphi_h$). The dark current can be attenuated and reach a value lower than the minimum value described above.

However, the trapping of the Fermi level at the metal/semiconductor interface observed in III-V semiconductors [Ref. 6] does not provide access to a dynamic range for changing the barrier height as large as that observed for silicon for example. Indeed, the difficulty of producing metal/III-V semiconductor interfaces in a reproducible and industrial way considerably limits the possibilities of modifying the height of Schottky barriers on such semiconductors.

There is thus a need for alternative designs of MSM photodetectors that show very low dark current densities even when using low bandgap semiconductor layers to absorb light of long wavelength.

SUMMARY

In what follows, the term "comprises" is synonym of (means the same as) "includes" and "contains", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present description relates to a photodetector configured to detect incident light in a given range of wavelengths comprising:

an absorbing semiconductor layer configured to absorb light within said given range of wavelengths;

a first semiconductor layer made of a first semiconductor material and in electrical contact with said absorbing semiconductor layer;

a first metal electrode configured to be electrically connected to a negative pole of a voltage generator, wherein the first metal electrode is in electrical contact with the first semiconductor layer, the first semiconductor layer is arranged between said first metal electrode (340) and the absorbing semiconductor layer, and wherein the first metal electrode and the first semiconductor layer are configured to produce an electron Schottky junction under application of a bias voltage;

a second semiconductor layer made of a second semiconductor material different from the first semiconductor material, in electrical contact with said absorbing semiconductor layer;

a second metal electrode configured to be electrically connected to a positive pole of said voltage generator, wherein the second metal electrode is in electrical contact with the second semiconductor layer, the second semiconductor layer is arranged between said second metal electrode and the absorbing semiconductor layer and wherein the second metal electrode and the second semiconductor layer are configured to produce a hole Schottky junction under application of a bias voltage.

In the electron Schottky junction, the current under application of a bias voltage, for example a bias voltage greater than a few $k_BT$, i.e. a bias voltage equal to or greater than around 0.1 V at ambient temperature, is dominated by the flux of electrons across the junction.

In the hole Schottky junction, the current under application of a bias voltage, for example a bias voltage greater than a few $k_BT$, i.e. a bias voltage equal to or greater than around 0.1V at ambient temperature, is dominated by the flux of holes across the junction.

By virtue of such original arrangement, it is possible, at a given bias voltage, to separately minimize the two components of the dark current density: on the one hand the current density of electrons injected by the electron Schottky junction into the absorbing semiconductor layer and on the other hand the hole current density injected by the hole Schottky junction into the absorbing semiconductor layer. This is made possible by the asymmetry between the first semiconductor layer, also referred to in the present description as the "electron Schottky semiconductor layer" and the second semiconductor layer, also referred to in the present description as the "hole Schottky semiconductor layer" made of different semiconductor materials.

According to one or a plurality of embodiments, the absorbing semiconductor layer comprises a semiconductor material chosen among: germanium, a III-V compound or a II-VI compound. For example, the absorbing semiconductor layer comprises a semiconductor material chosen among: InGaAlAs alloys, for example InGaAs (bandgap Eg = 0.79 eV) for detection up to 1.6 $\mu$m, InAs/(In,Ga)Sb type-II superlattices, or HgCdTe alloys for larger wavelengths (up to 14 $\mu$m).

According to one or a plurality of embodiments, the absorbing semiconductor layer comprises silicon.

According to one or a plurality of embodiments, the first semiconductor material and/or the second semiconductor material are chosen among: the InGaAlAs alloys, for example InAlAs, the InGaAsP alloys, for example InP, the HgCdTe alloys, for example CdTe.

According to one or a plurality of embodiments, the first metal electrode and/or the second metal electrode comprise one or a plurality of the following materials: titanium, platinum, aluminum, chromium, tungsten, molybdenum and compounds as tungsten silicide ($WSi_x$), molybdenum silicide ($MoSi_x$).

According to one or a plurality of embodiments, the first metal electrode and/or the second metal electrode comprise a stack of different metals.

According to one or a plurality of embodiments, the first semiconductor material and the first metal electrode are chosen such that the electron Schottky junction has an electron Schottky barrier $\varphi_e$ greater than half the bandgap of the first semiconductor layer and the second semiconductor material and the second metal electrode are chosen such that the hole Schottky junction has a hole Schottky barrier $\varphi_h$ greater than half the bandgap of the second semiconductor layer. Compared to photodetectors of the prior art, each of the current density of electrons $I_e$ and the current density of holes $I_h$ can both be reduced, resulting in a reduced dark current and a better sensitivity.

According to one or a plurality of embodiments, the photodetector further comprises a first graded semiconductor heterostructure in contact with a surface of the absorbing semiconductor layer and a surface of the first semiconductor layer.

According to one or a plurality of embodiments, the photodetector further comprises a second graded semiconductor heterostructure in contact with a surface of the absorbing semiconductor layer and a surface of the second semiconductor layer.

In the present description, a graded semiconductor heterostructure is a stack of several semiconductor layers exhibiting a gradation of the bandgap ranging from a value close to that of the absorbing semiconductor layer at the interface therewith to a value close to that of the semiconductor layer at the opposite interface. A graded semiconductor heterostructure may be obtained by a stacking of several layers of semiconductors with different bandgaps or by a gradual variation of the composition of a quaternary semiconductor alloy (e.g. InAlGaAs or InGaAsP).

A graded semiconductor heterostructure may allow to eliminate the discontinuities of the conduction and valence bands that could exist between two different semiconductor layers. By reducing parasitic potential barriers, a better collection of the photo-generated carriers of charge (electrons and holes) is obtained, therefore leading to a better quantum efficiency of the photodetector.

According to one or a plurality of embodiments, the photodetector further comprises an interfacial layer in contact with a surface of said first semiconductor layer and a surface of said first metal electrode and/or an interfacial layer in contact with a surface of said second semiconductor layer and a surface of said second metal electrode.

For example, said interfacial layer comprises an oxide, for example a silicon oxide, an indium phosphide oxide or an InAlAs oxide. This oxide layer may be used to control the Schottky barrier of the Schottky junction by adjusting its thickness.

According to one or a plurality of embodiments, the first metal electrode is arranged on a first side of the absorbing semiconductor layer and the second metal electrode is arranged on a second side of the absorbing semiconductor layer, opposite to the first side. This is referred to as a vertical arrangement of the photodetector in the present description.

In such vertical arrangement, a first graded semiconductor heterostructure may be arranged in contact with a surface of the absorbing semiconductor layer and a surface of the first semiconductor layer and/or a second graded semiconductor heterostructure may be ' arranged in contact with a surface of the absorbing semiconductor layer and a surface of the second semiconductor layer.

According to one or a plurality of embodiments, the first metal electrode and the second metal electrode are arranged on a same side of the absorbing semiconductor layer. This is referred to as a horizontal arrangement of the photodetector in the present description.

In such horizontal arrangement, a first graded semiconductor heterostructure may be arranged in contact with a surface of the absorbing semiconductor layer and a surface of the first semiconductor layer or a second graded semiconductor heterostructure may be arranged in contact with a surface of the absorbing semiconductor layer and a surface of the second semiconductor layer.

Further, a third graded semiconductor heterostructure may be arranged in contact with a surface of the first semiconductor layer and a surface of the second semiconductor layer.

According to a second aspect, the present description refers to a photodetection circuit comprising:

a photodetector according to the first aspect;
a voltage generator, wherein the first metal electrode is electrically connected to a negative pole of the voltage generator and the second metal electrode is electrically connected to a positive pole of the voltage generator.

According to a third aspect, the present description refers to a method for fabricating a photodetector according to the first aspect.

In some embodiments, the method according to the second aspect comprises:

depositing on a substrate a semiconductor stack comprising the absorbing semiconductor layer, the first semiconductor layer, the second semiconductor layer;
depositing on the semiconductor stack a metal layer to make the first metal electrode;
flipping the substrate together with the semiconductor stack and pasting on a host substrate;
etching the substrate and depositing a metal layer to make the second electrode.

According to one or a plurality of embodiments, the semiconductor stack further comprises a first graded semiconductor heterostructure in contact with a surface of the absorbing semiconductor layer and a surface of the first semiconductor layer and/or a second graded semiconductor heterostructure in contact with a surface of the absorbing semiconductor layer and a surface of the second semiconductor layer.

BRIEF DESCRIPTION OF DRAWINGS

Other advantages and features of the invention will become apparent on reading the description, illustrated by the following figures which represent:

Fig. 1A, already described, represents a sectional view of a MSM photodetector (vertical arrangement), according to the prior art.
Fig. 1B, already described, represents a sectional view of a MSM photodetector (horizontal arrangement), according to the prior art.
Fig. 2A, already described, represents a theoretical energy band diagram of a MSM photodetector of the prior art, using the same metal for both electrodes.
Fig. 2B, already described, represents a theoretical energy band diagram of a MSM photodetector of the prior art, using different metals for both electrodes.
Fig. 3A, represents a photodetection circuit with a sectional view of a MSM photodetector (vertical arrangement), according to an embodiment of the present description.
Fig. 3B, represents a photodetection circuit with a sectional view of a MSM photodetector (horizontal arrangement), according to an embodiment of the present description.
Fig. 4A, represents a theoretical energy band diagram of a MSM photodetector according to an embodiment of the present description, using the same metal for both electrodes and different semiconductor materials at the metal-semiconductor interfaces.
Fig. 4B, represents a theoretical energy band diagram of a MSM photodetector according to an embodiment of the present description, using different metals and different semiconductor materials at the metal semiconductor interfaces.
Fig. 5A, represents a photodetection circuit with a sectional view of a MSM photodetector (vertical arrangement), according to an embodiment of the present description.
Fig. 5B, represents a theoretical energy band diagram of a MSM photodetector as illustrated in Fig. 5A, according to an embodiment of the present description.
Fig. 6A, represents a photodetection circuit with a sectional view of a MSM photodetector (horizontal arrangement), according to an embodiment of the present description.
Fig. 6B, represents a theoretical energy band diagram of a MSM photodetector in a horizontal arrangement, according to an embodiment of the present description.
Fig. 7A, represents a photodetection circuit with a sectional view of a MSM photodetector (horizontal arrangement), according to an embodiment of the present description.
Fig. 7B, represents a theoretical energy band diagram of a MSM photodetector in a horizontal arrangement, according to an embodiment of the present description.
Fig. 8, represents curves showing the calculated dark current density as a function of the electron barrier height in an embodiment of a photodetector according to the present description.
Fig. 9A, represents a first step of a method for fabricating an asymmetric MSM photodetector according to an embodiment of the present description.
Fig. 9B, represents a second step of a method for fabricating an asymmetric MSM photodetector according to an embodiment of the present description.
Fig. 9C, represents a third step of a method for fabricating an asymmetric MSM photodetector according to an embodiment of the present description.
Fig. 9D, represents a fourth step of a method for fabricating an asymmetric MSM photodetector according to an embodiment of the present description.
Fig. 9E, represents a fifth step of a method for fabricating an asymmetric MSM photodetector according to an embodiment of the present description.

DETAILED DESCRIPTION

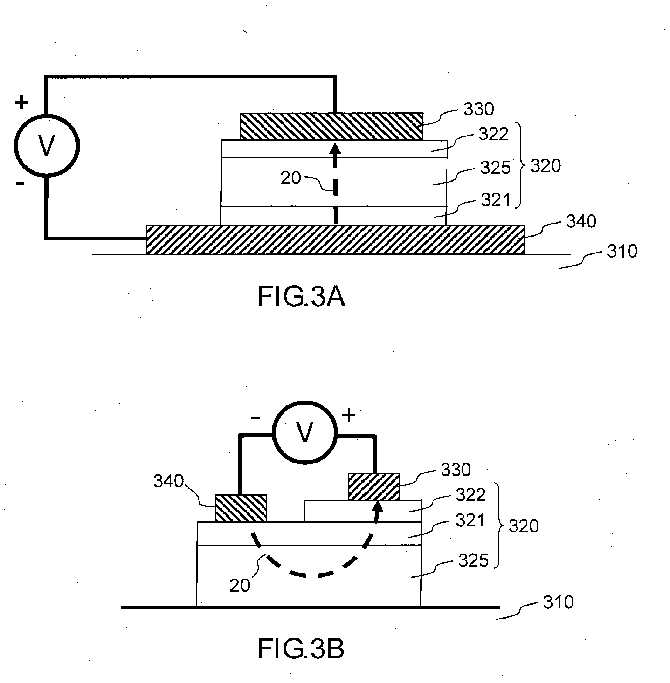

Fig. 3A and Fig. 3B illustrate photodetection circuits with two configurations of MSM photodetectors according to embodiments of the present description. In these embodiments, two metal electrodes 330, 340 are deposited on either side of an absorbing semiconductor layer 325 ("vertical arrangement", Fig. 3A) or on the same side of the absorbing semiconductor layer 325 ("horizontal arrangement", Fig. 3B). V is the bias voltage applied to the metal electrodes 330, 340 and the line 20 shows an arbitrary line that follows a current density line between the two electrodes, in a 1D approximation.
The MSM photodetectors are configured to detect incident light in a given range of wavelengths, for example between around 1.3 $\mu$m and around 1.5 $\mu$m for optical communication applications, for example around 1.3 $\mu$m or

around 1.5 $\mu$m.

In the embodiments of Fig. 3A and Fig. 3B, the MSM photodetectors comprise a support 310 and a semiconductor stack comprising the absorbing semiconductor layer 325, a first semiconductor layer 321 in electrical contact with the absorbing semiconductor layer and a second semiconductor layer 322 in electrical contact with the absorbing semiconductor layer. The absorbing semiconductor layer 325 is configured to absorb light within said range of wavelengths.

In a vertical arrangement as shown for example in Fig. 3A, the semiconductor stack is transferred on a host substrate. The support 310 corresponds to the host substrate and can be any mechanical support, for example a metal (for example Al or Cu), glass (for example SiO2) or a semiconductor (for example silicon)..

In a horizontal arrangement as shown for example in Fig. 3B, the support 310 comprises for example indium phosphide (InP) substrate for the growth of InGaAlAs and/or InGaAsP alloys, or gallium arsenide (GaAs) substrate for the growth of AlGaAs alloys, or CdZnTe for the growth of HgCdTe alloys, or GaSb or InAs substrate for the growth of type-2 superlattice GaSb/InAs.

The first semiconductor layer 321 is made of a first semiconductor material and is in electrical contact with a first metal electrode 340 (the cathode in the example of Fig. 3A and Fig. 3B), thus forming in these embodiments a first semiconductor-metal interface. The first metal electrode 340 produces with the first semiconductor layer 321 an electron Schottky junction having a Schottky barrier height $\varphi_e$ seen by the electrons. In the description, the first semiconductor layer 321 is thus also referred to as the "electron Schottky semiconductor layer".

The second semiconductor layer 322 is made of a second semiconductor material different from the first semiconductor material and in electrical contact with the second electrode 330 (the anode in the example of Fig. 3A and Fig. 3B), thus forming in these embodiments a second semiconductor-metal interface. The second metal electrode 330 is made of a metal which may or may not be the same as the metal of the first metal electrode 340. The second electrode 330 produces with the second semiconductor layer 322 a hole Schottky junction having a Schottky barrier height $\varphi_h$ seen by the holes. In the description, the second semiconductor layer 322 is thus also referred to as the "hole Schottky semiconductor layer".

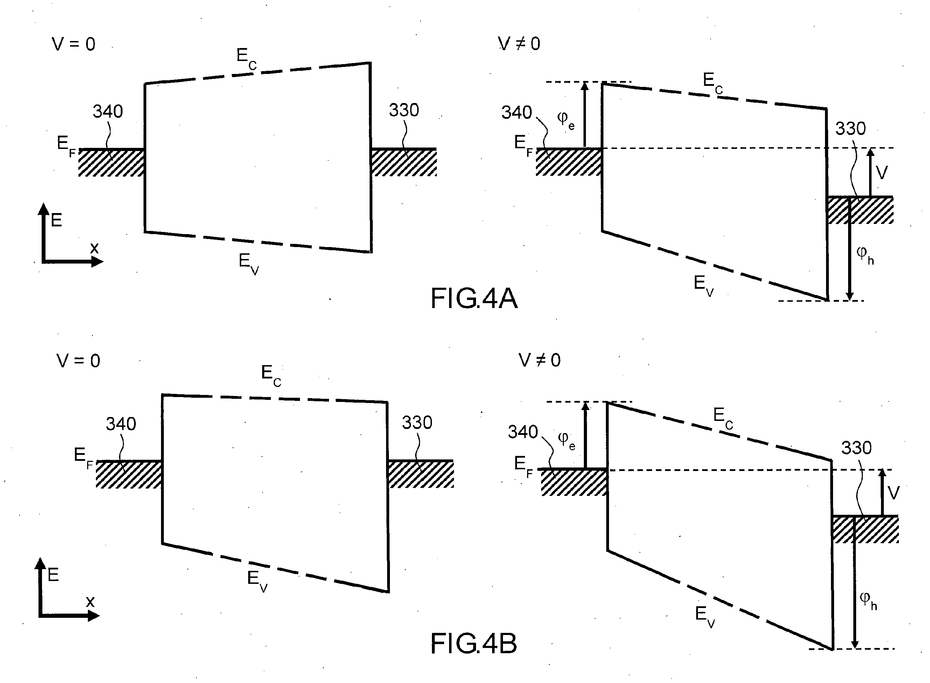

Fig. 4A and Fig. 4B illustrate energy band diagrams of embodiments of MSM photodetectors as shown in Fig. 3A and 3B. The energy band diagrams are shown for a bias voltage applied between the first and second metal electrodes 340, 330 for V=0 (left) and V≠0 (right). In the embodiment of Fig. 4A, first and second electrodes 340, 330 are made with the same metal, while in the embodiment of Fig. 4B, first and second electrodes 340, 330 are made with different metals.

As shown in Fig. 4A, at V=0, the Fermi level $E_F$ of the metal is located at the same energy level (along the E-axis) at both metal-semiconductor interfaces, but Ec and Ev are not parallel indicating the presence of a quasi-electric field within the semiconductor stack. In the energy band diagrams, the dashed line is only a guide for the eye: the semiconductor stack is not defined between the two interfaces in these schemes. In operation, a bias voltage V is applied to establish a collecting electric field for the collection of the photocarriers. As shown in Fig. 4A, the potential barrier seen by the electron injected in the first semiconductor layer (electron Schottky barrier height $\varphi_e$) and the potential barrier seen by the hole injected in the second semiconductor layer (hole Schottky barrier height $\varphi_h$) can be controlled independently since the semiconductor materials at the metal-semiconductor interfaces are different; in this case, the sum of the two barrier heights is therefore no longer fixed at a value equal to the semiconductor bandgap as it was in the prior art. On the contrary, the present description allows each of these barrier heights to be greater than half of the bandgap of the corresponding semiconductor layer in contact with each of these electrodes.

Fig. 4B illustrates an energy band diagram of MSM photodetectors as shown for example in Fig. 3A and Fig. 3B, using different metals for both electrodes (330 and 340) and different semiconductor materials for the electron Schottky semiconductor layer 321 and the hole Schottky semiconductor layer 322 at the metal-semiconductor interfaces. In this case, one metal-semiconductor interface is chosen to have a high electron Schottky barrier height and the other metal-semiconductor interface is chosen to have a high hole Schottky barrier height. The two potential barriers can therefore be maximized independently so that both the electrons and the holes injected from the electrodes into the semiconductor layers 321, 322 respectively, have a higher barrier height to overcome compared to Fig. 2B.

The current at the two Schottky junctions are thus extremely reduced and so is the dark current density of the MSM photodetector.

By virtue of the original arrangements as described for example in Fig. 3A and Fig. 3B, an asymmetry is therefore obtained between the interface metal electrode 340 - electron Schottky semiconductor layer 321 and the interface metal electrode 330 - hole Schottky semiconductor 322. This asymmetry makes it possible to separately minimize the current density of electrons injected by the electron Schottky junction into the electron Schottky semiconductor layer 321 and the hole current injected by the hole Schottky junction into the hole Schottky semiconductor layer 322.

It is then possible for the skilled man to determine, among the available materials, the semiconductor material/metal couples which form the Schottky junctions having the weakest current densities (electron and hole) under reverse bias. For example, for each of the two junctions (electron and hole), it is possible to fabricate a structure specific for the test. Such structure comprises for example the metal layer and the Schottky semiconductor layer to be tested, the latter being epitaxially grown on a doped semiconductor, with N type to test the Electron Schottky semiconductor - metal interface, or with P type to test the Hole Schottky semiconductor - metal interface.

By way of example, the test procedure described above made it possible to determine the barrier heights of the Schottky junctions produced by a Ti/Au contact on InAlAs for the electrons and on InP for the holes.

The inventors determined a barrier height seen by the electrons at the Schottky InAlAs / Ti / Au junction $\varphi_e$ = 735 meV, i.e. a dark current density $I_e$ = 4 fA.$\mu$m$^{-2}$.

The inventors further determined a barrier height seen by the holes at the Schottky InP / Ti / Au junction $\varphi_h$ = 786 meV, i.e. a dark current density $I_h$ = 0.5 fA.$\mu$m$^{-2}$.

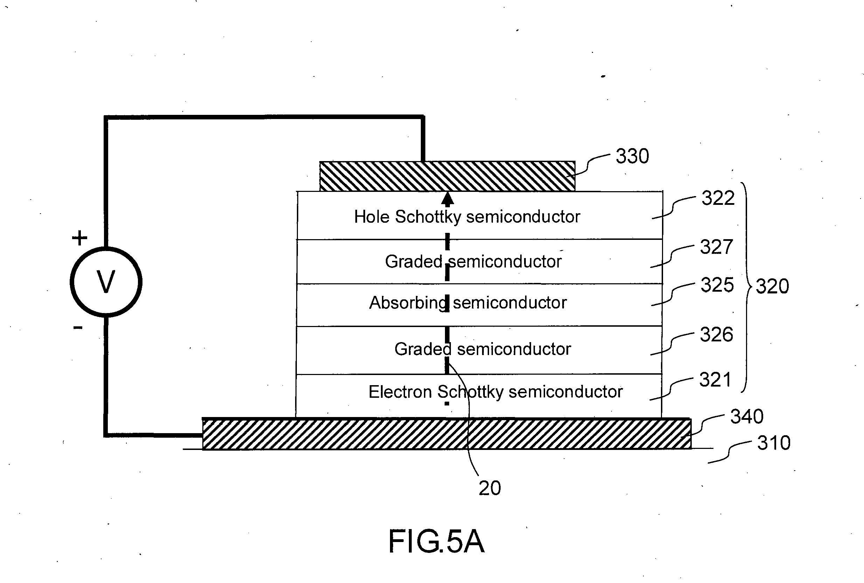

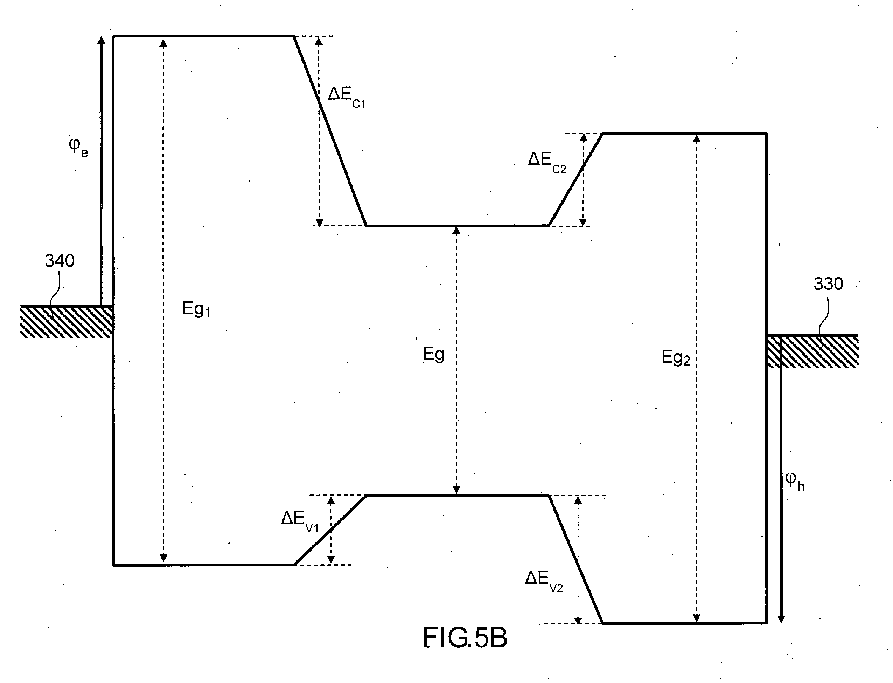

It follows that the dark current density for the MSM photodetector (sum of the electron current injected at the InAlAs/Ti/Au junction and the hole current injected at the InP/Ti/Au junction) is equal to: 4.5 fA.$\mu$m$^{-2}$, i.e. 28 times less than the absolute minimum current density of a symmetrical detector as described for symmetric MSM photodetectors using Au/Ti/InP (gold/titanium/indium phosphide) as Schottky contacts. Figs. 5A, 6A, 7A show other embodiments of MSM photodetectors according to embodiments of the present description and Figs. 5B, 6B, 7B show band diagrams of MSM photodetectors according to embodiments of the present description. In Figs 5B, 6B, 7B, for simplicity, the electric field in each layer is taken equal to zero.

Fig. 5A illustrates another embodiment of a MSM photodetector according to embodiments of the present description, in a vertical arrangement.

The MSM photodetector illustrated in Fig. 5A comprises a semiconductor stack 320 with an absorbing semiconductor layer 325, an electron Schottky semiconductor layer 321 and a hole Schottky semiconductor layer 322. The semiconductor stack further comprises a first graded semiconductor heterostructure 326 in contact with a surface of the absorbing semiconductor layer 325 and in contact with a surface of the electron Schottky semiconductor layer 321, and a second graded semiconductor heterostructure 327 in contact with a surface of the absorbing semiconductor layer 325 and a surface of the hole Schottky semiconductor layer 322. In such vertical arrangement, the metal electrodes 330, 340 are arranged on either side of the semiconductor stack and are in electrical contact respectively with the hole Schottky semiconductor layer 322 and the electron Schottky semiconductor layer 321.

For example, when the absorbing semiconductor layer 325 is made of InGaAs and the electron Schottky semiconductor layer 321 is made ofInAlAs, the first graded semiconductor heterostructure 326 may comprise an alloy of InGaAlAs and may thus have a bandgap that varies from the bandgap of InAlAs to the bandgap of InGaAs.

The first graded semiconductor heterostructure 326 enables smoothing the discontinuities of the conduction and valence bands that exist between the absorbing semiconductor layer 325 and the electron Schottky semiconductor layer 321. By limiting the resulting parasitic potential barriers, a better collection of the photo-generated charge carriers can be performed.

On the other hand, when the absorbing semiconductor layer 325 is made of InGaAs and the hole Schottky semiconductor layer 322 is made of InP, the second graded semiconductor heterostructure 327 may comprise an alloy of InGaAsP and may thus have a bandgap that varies from the bandgap of InP to the bandgap of InGaAs.

Note that in some embodiments, the MSM photodetector may comprise only one of the first graded semiconductor heterostructure or the second graded semiconductor heterostructure, although a better performance is expected with both graded semiconductor heterostructures.

Fig. 5B represents the band diagram of a MSM photodetector as shown in Fig. 5A. The semiconductor stack comprises an absorbing semiconductor layer 325 having a bandgap $E_g$, an electron Schottky semiconductor layer 321 having a bandgap $E_{g1}$, a hole Schottky semiconductor layer 322 having a bandgap $E_{g2}$, a first graded semiconductor heterostructure 326 arranged between the electron Schottky semiconductor layer 321 and the absorbing semiconductor layer 325, and a second graded semiconductor heterostructure 327 arranged between the hole Schottky semiconductor layer 322 and the absorbing semiconductor layer 325.

For example, the electrodes 330, 340 comprise a stack of two metal layers, a titanium layer and a gold layer. The titanium layer in the first metal electrode 340 generates with the first semiconductor layer 321 the electron Schottky barrier, and the titanium layer in the second metal electrode 330 generates with the second semiconductor layer 322 the hole Schottky barrier. The gold layer is used as an inert metal to protect the titanium, and is further a very good conductor.

The absorbing semiconductor layer 325 is made of InGaAs with a bandgap $E_g$ = 0.74 eV. The electron Schottky semiconductor layer 321 is made of InAlAs with a bandgap $E_{g1}$ = 1.45 eV, thus producing at the titanium-InAlAs interface an electron Schottky junction exhibiting a high potential barrier $\varphi_e$ = 0.73 eV for electrons injected from titanium into InAlAs. The hole Schottky semiconductor layer 322 is made of InP with a bandgap $E_{g2}$ = 1.35 eV, thus producing at the titanium-InP interface a hole Schottky junction exhibiting a high potential barrier $\varphi_h$ = 0.79 eV for holes injected from titanium into InP.

In Fig. 5B, we note $\Delta E_{C1}$ and $\Delta E_{C2}$ respectively the energy difference between the conduction bands of the electron Schottky semiconductor layer 321 and the absorbing semiconductor layer 325, and the energy difference between the conduction bands of the hole Schottky semiconductor layer 322 and the absorbing semiconductor layer

325. For example, $\Delta E_{C1}$ = 0.52 eV in the example described above and $\Delta E_{C2}$ = 0.25 eV.

Further, we note $\Delta E_{V1}$ and $\Delta E_{V2}$ respectively the energy difference between the valence bands of the absorbing semiconductor layer 320 and the electron Schottky semiconductor layer 321, and the energy difference between the valence bands of the absorbing semiconductor layer 325 and the hole Schottky semiconductor layer 322. For example, $\Delta E_{V1}$ = 0.19 eV in the example described above and $\Delta E_{V2}$ = 0.35 eV.

In this example again, the dark current is considerably reduced compared to a symmetric MSM photodetector of the prior art (28 less compared to the Au/Ti/InP junctions of a symmetric MSM photodetector). Further, the same metal can be used for both electrodes, which simplifies the manufacturing.

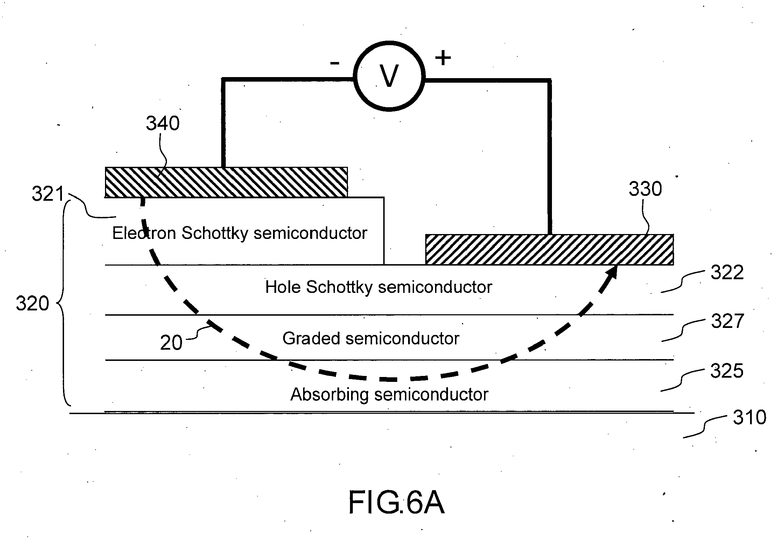

Fig. 6A illustrates another embodiment of a MSM photodetector according to embodiments of the present description, in a horizontal arrangement.

The MSM photodetector illustrated in Fig. 6A comprises a semiconductor stack 320 and two electrodes 330, 340 arranged on top of the semiconductor stack. The semiconductor stack 320 comprises an absorbing semiconductor layer 325, an electron Schottky semiconductor layer 321 in electrical contact with the first electrode 340 and a hole Schottky semiconductor layer 322 in electrical contact with the second electrode 330. In the example of Fig. 6A, the hole Schottky semiconductor layer 322 is arranged between the electron Schottky semiconductor layer 321 and the absorbing semiconductor layer 325. Further, the electron Schottky semiconductor layer 321 is structured so that the second electrode 330 may be arranged in contact with the hole Schottky semiconductor layer 322. Advantageously, in the example of Fig. 6A, the semiconductor stack further comprises a graded semiconductor heterostructure 327 in contact with a surface of the absorbing semiconductor layer 325 and in contact with a surface of the hole Schottky semiconductor layer 322. Note that the semiconductor stack may also further comprise a graded semiconductor heterostructure (not shown in Fig. 6A) in contact with a surface of the electron Schottky semiconductor layer 321 and in contact with a surface of the hole Schottky semiconductor layer 322.

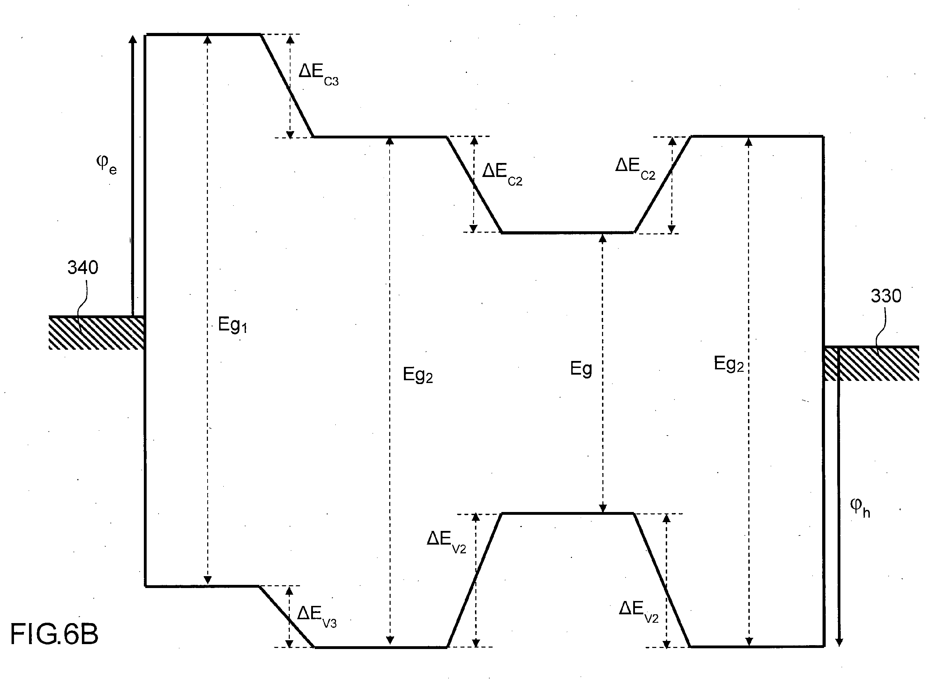

Fig. 6B represents the band diagram of a MSM photodetector as shown in Fig. 6A, wherein a graded semiconductor heterostructure is further arranged, in contact with a surface of the electron Schottky semiconductor layer 321 and in contact with a surface of the hole Schottky semiconductor layer 322. As detailed above, the semiconductor stack comprises an absorbing semiconductor layer 325 having a bandgap $E_g$, an electron Schottky semiconductor layer 321 having a bandgap $E_{g1}$ and a hole Schottky semiconductor layer 322 having a bandgap $E_{g2}$; in such embodiment, the electron Schottky semiconductor 321 is grown on top of the hole Schottky semiconductor 322. Further, a graded semiconductor heterostructure 327 is arranged between the hole Schottky semiconductor layer 322 and the absorbing semiconductor layer 325 and a graded semiconductor heterostructure (not shown in Fig. 6A) is arranged between the electron Schottky semiconductor layer 321 and the hole Schottky semiconductor layer 322.

For example, the electrodes 330, 340 are made of titanium/gold. The absorbing semiconductor layer 325 is made of InGaAs with a bandgap $E_g$ = 0.74 eV. The electron Schottky semiconductor layer 321 is made of InAlAs with a bandgap $E_{g1}$ = 1.45 eV, thus producing at the titanium-InAlAs interface an electron Schottky-junction exhibiting a high potential barrier $\varphi_e$ = 0.73 eV for electrons injected from titanium into InAlAs. The hole Schottky semiconductor layer 322 is made of InP with a bandgap $E_{g2}$ = 1.35 eV, thus producing at the titanium-InP interface a hole Schottky junction exhibiting a high potential barrier $\varphi_h$ = 0.79 eV for holes injected from titanium into InP.

In Fig. 6B, $\Delta E_{C2}$ is the energy difference between the conduction bands of the hole Schottky semiconductor layer 322 and the absorbing semiconductor layer 325. $\Delta E_{C3}$ is the energy difference between the conduction bands of the electron Schottky semiconductor layer 321 and the hole Schottky semiconductor layer 322. For example, $\Delta E_{C2}$ = 0.25 eV, $\Delta E_{C3}$ = 0.34 eV in the example described above.

Further, $\Delta E_{V2}$ is the energy difference between the valence bands of the absorbing semiconductor layer 325 and the hole Schottky semiconductor layer 322. $\Delta E_{V3}$ is the energy difference between the valence bands of the electron Schottky semiconductor layer 321 and the hole Schottky semiconductor layer 322. For example, $\Delta E_{V2}$ = 0.35 eV and $\Delta E_{V3}$ = 0.19 eV in the example described above.

We observe the same reduction of the dark current compared to a symmetric MSM photodetector of the prior art.

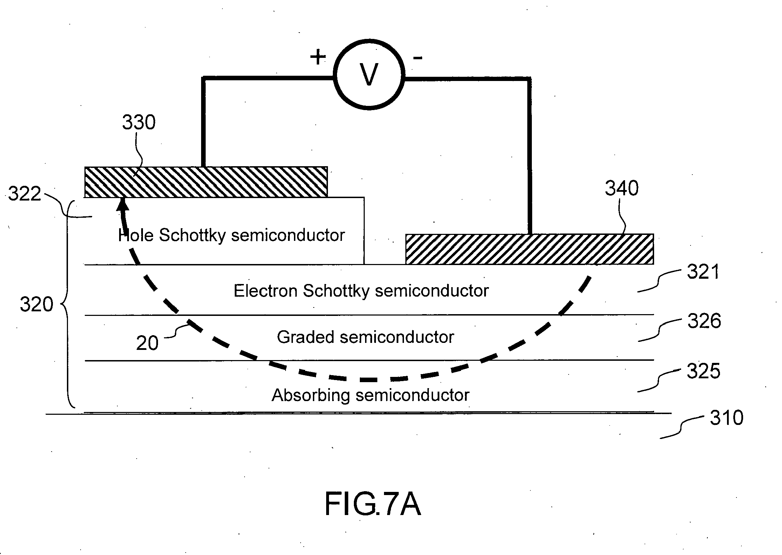

Fig. 7A illustrates another embodiment of a MSM photodetector according to embodiments of the present description, in a horizontal arrangement.

The MSM photodetector illustrated in Fig. 7A comprises a semiconductor stack 320 and two electrodes 330, 340 arranged on top of the semiconductor stack. The semiconductor stack comprises an absorbing semiconductor layer 325, an electron Schottky semiconductor layer 321 in electrical contact with the first electrode 340 and a hole Schottky semiconductor layer 322 in electrical contact with the second electrode 330. In the example of Fig. 7A, the electron Schottky semiconductor layer 321 is arranged between the hole Schottky semiconductor layer 322 and the absorbing semiconductor layer 325. Further, the hole Schottky semiconductor layer 322 is structured so that the first electrode 340 may be arranged in contact with the electron Schottky semiconductor layer 321. Advantageously, in the example of Fig. 7A, the semiconductor stack further comprises a graded semiconductor heterostructure 326 in contact with a surface of the absorbing semiconductor layer 325 and in contact with a surface of the electron Schottky semiconductor layer 321. The semiconductor stack may also further comprise a graded semiconductor heterostructure (not shown in Fig.

7A) in contact with a surface of the electron Schottky semiconductor layer 321 and in contact with a surface of the hole Schottky semiconductor layer 322.

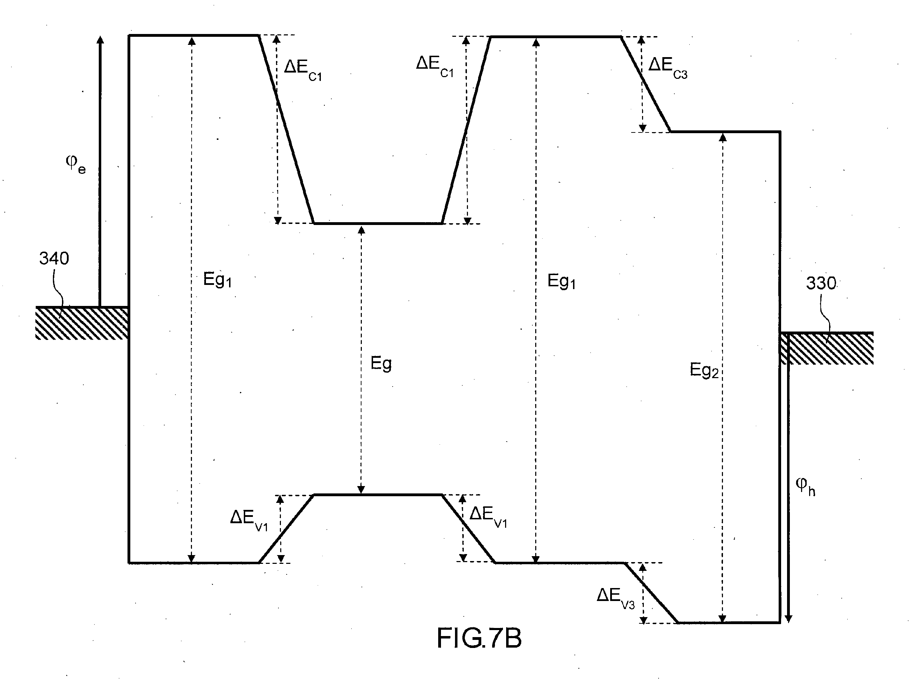

Fig. 7B represents the band diagram of a MSM photodetector as shown in Fig. 7A, wherein a graded semiconductor heterostructure is further arranged, in contact with a surface of the electron Schottky semiconductor layer 321 and in contact with a surface of the hole Schottky semiconductor layer 322. As detailed above, the semiconductor stack comprises an absorbing semiconductor layer 325 having a bandgap $E_g$, an electron Schottky semiconductor layer 321 having a bandgap $E_{g1}$ and a hole Schottky semiconductor layer 322 having a bandgap $E_{g2}$; in this embodiment, the hole Schottky semiconductor 322 is grown on top of the electron Schottky semiconductor 321. Further, a graded semiconductor heterostructure 326 is arranged between the electron Schottky semiconductor layer 321 and the absorbing semiconductor layer 325 and a graded semiconductor heterostructure (not shown in Fig. 7A) is arranged between the electron Schottky semiconductor layer 321 and the hole Schottky semiconductor layer 322.

For example, the electrodes 330, 340 are made of titanium/gold. The absorbing semiconductor layer 325 is made of InGaAs with a bandgap $E_g$ = 0.74 eV. The electron Schottky semiconductor layer 321 is made of InAlAs with a bandgap $E_{g1}$ = 1.45 eV, thus producing at the titanium-InAlAs interface an electron Schottky junction exhibiting a high potential barrier $\varphi_e$ = 0.73 eV for electrons injected from titanium into InAlAs. The hole Schottky semiconductor layer 322 is made of InP with a bandgap $E_{g2}$ = 1.35 eV, thus producing at the titanium-InP interface a hole Schottky junction exhibiting a high potential barrier ($\varphi_h$ = 0.79 eV for holes injected from titanium into InP.

In Fig. 7B, $\Delta E_{C1}$ is the energy difference between the conduction bands of the electron Schottky semiconductor layer 321 and the absorbing semiconductor layer 325. $\Delta E_{C3}$ is the energy difference between the conduction bands of the electron Schottky semiconductor layer 321 and the hole Schottky semiconductor layer 322. For example, $\Delta E_{C1}$ = 0.52 eV and $\Delta E_{C3}$ = 0.34 eV.

Further, $\Delta E_{V1}$ is the energy difference between the valence bands of the absorbing semiconductor layer 325 and the electron Schottky semiconductor layer 321. $\Delta E_{V3}$ is the energy difference between the valence bands of the electron Schottky semiconductor layer 321 and the hole Schottky semiconductor layer 322. For example, $\Delta E_{V1}$ = 0.19 eV and $\Delta E_{V3}$ = 0.19 eV.

The advantages of this arrangement are the same as those described for Fig. 6A, 6B. Further, as the transport of the holes is slower than that of the electrons the arrangement of Fig. 7A may be advantageous as the average path of the holes to their collecting electrode is reduced.

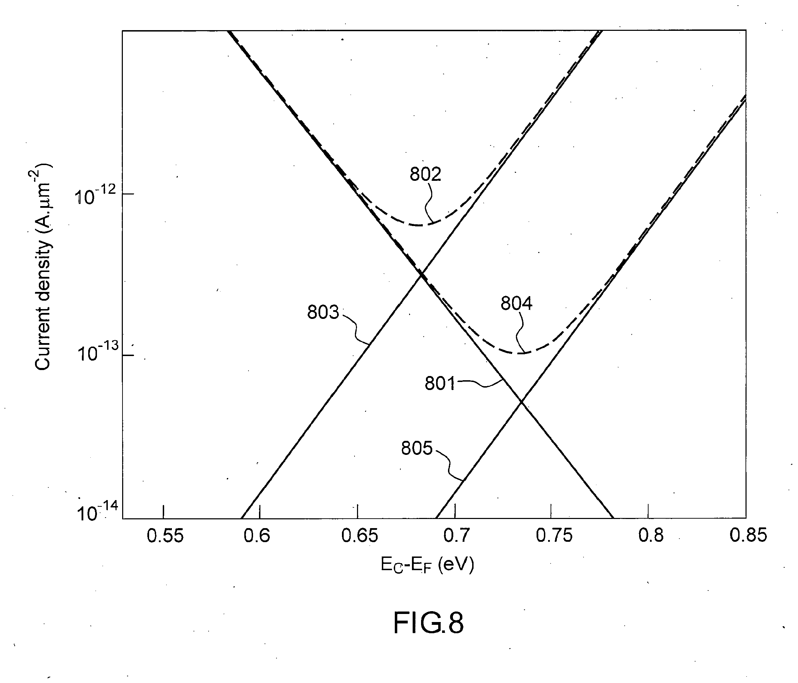

Fig. 8 represents curves showing the calculated dark current density as a function of the electron barrier height in an embodiment of a photodetector according to the present description, compared to the calculated dark current in a photodetector of the prior art.

In Fig. 8, curve 801 is the calculated electron dark current density calculated for the titanium / InP Schottky junction as a function of the difference between the minimum energy $E_c$ of the conduction and the Fermi level $E_F$, which is, in a good approximation, equal to the Schottky barrier height seen by the electrons injected from the titanium layer into the InP layer. Curve 803 illustrates the calculated hole dark current density for the same Schottky junction. The sum 802 of the two current densities corresponds to the dark current density in a symmetric MSM photodetector according to the prior art. It has a minimum corresponding to a best optimization of the photodetector. Such minimum is an absolute minimum and is dependent on the nature of the materials (semiconductor and metal) used for the Schottky junctions.

Fig. 8 also illustrates the calculated dark current density 804 in an asymmetric MSM photodetector according to the present description. In this example, the electron Schottky Semiconductor is InP, as in the previous case, and the hole Schottky Semiconductor is InAlAs. The metal electrodes are made of titanium. Curve 801 is the calculated electron dark current density and curve 805 the calculated hole dark current density. As shown in Fig. 8, the total current density 804 of the asymmetric MSM presents an absolute minimum lower than that of the symmetric MSM.

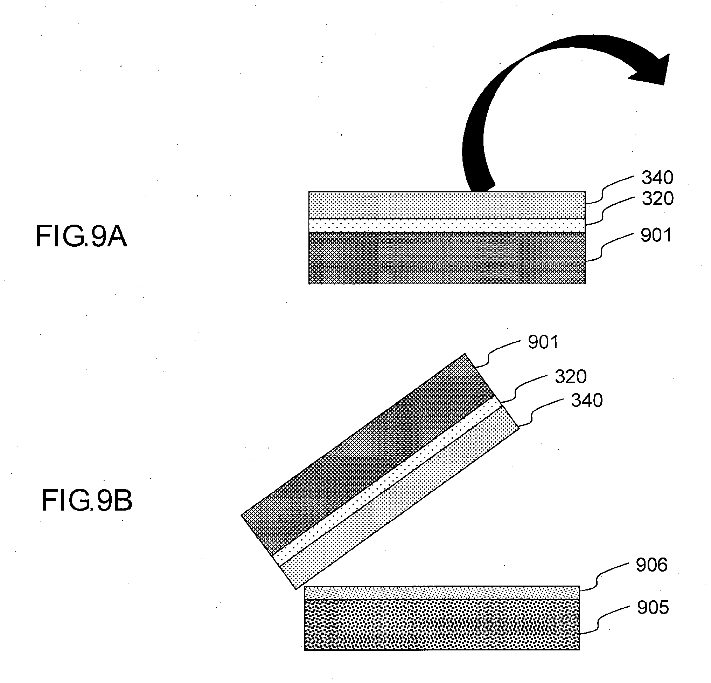

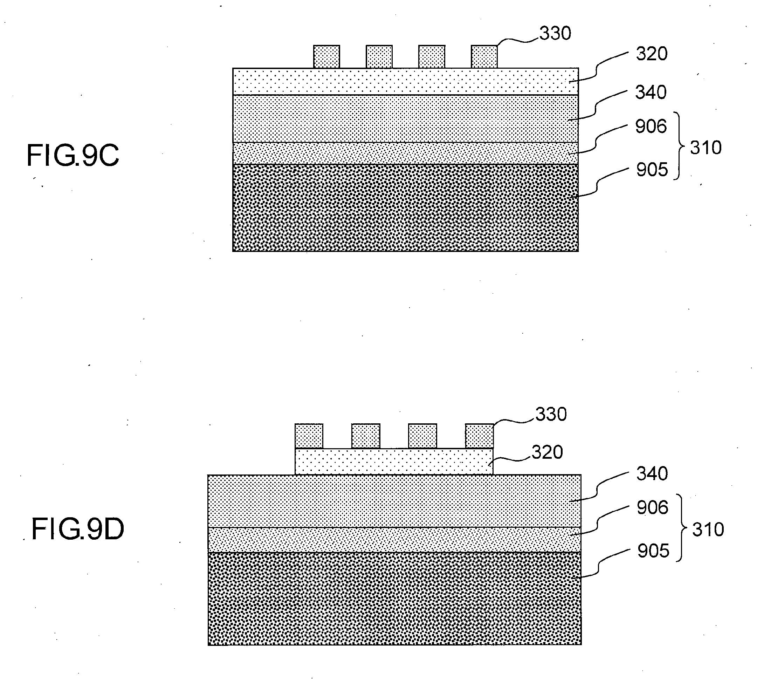

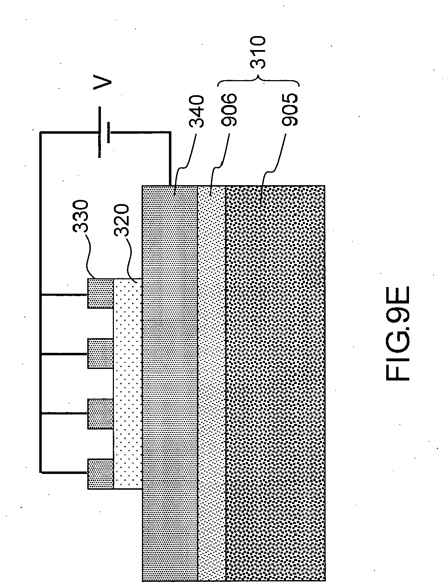

Figs. 9A, 9B, 9C, 9D, 9E illustrate steps of a method to fabricate an asymmetric MSM photodetector, according to embodiments of the present description.

In a first step (Fig. 9A), a semiconductor stack 320 comprising the absorbing semiconductor layer, the electron Schottky semiconductor layer, the hole Schottky semiconductor layer and the (optional) graded semiconductor layer(s) are deposited on a substrate 901, for example made of InP. The semiconductor stack 320 has a thickness comprised for example between about 500 nm and about 1000 nm. A metal layer 340 having a thickness comprised between about 150 nm and about 250 nm is deposited on the semiconductor stack 320 to make the first electrode of the MSM photodetector. The metal layer may comprise one metal, for example titanium, or a stack of metal layers, for example titanium/gold. Titanium is used as a diffusion barrier for gold to prevent gold atoms from diffusing into the semiconductor stack. Gold is an inert material and has therefore a low risk of oxidation with time; it also offers very low resistivity properties.

In a second step (Fig. 9B), the substrate 901 together with the semiconductor stack 320 and the metal layer 340 are flipped and pasted on a host substrate 905 using an adhesive layer 906. The host substrate is for example made of glass or silicon. The adhesive layer may comprise a polymer that offers glass-like properties after UV curing to paste the semiconductor stack on a substrate such as glass, or another type of polymer such as Benzocyclobutene BCB to paste the semiconductor stack on an opaque substrate such as silicon.

In a third step (Fig. 9C), the substrate 901 is etched and a metal layer 330 is deposited to make the second electrode. The metal layer 330 is for example of about 150 nm and may be structured, for example by optical lithography. The metal layer 330 may comprise one metal, for example titanium, or a stack of metal layer, for example Ti/Au.

In a fourth step (Fig. 9D), the semiconductor stack 320 is etched to fabricate a mesa that electrically isolates the photodetector. This step may be achieved using wet etching technique such as chemical solutions or using dry etching technique such as induced current plasma recipes.

As shown in Fig. 9E, a vertical MSM photodetector is obtained and a bias voltage V may be applied between the electrodes 330, 340.

While the method above was described for a vertical arrangement of a MSM photodetector, as described for example in Fig. 3A or 5A, the skilled man will adapt the method for a horizontal arrangement of a MSM photodetector, as described for example in Fig. 3B, 6A, 7A.

Since the electrodes of a horizontal arrangement are located on the same side of the semiconductor stack, the transfer of the stack on a host substrate (Fig. 9B) is optional. The following fabrication steps may be identical as those previously described: metal deposition forming the electrodes (Fig. 9C), isolation mesa (Fig. 9D). The connection to the external circuit (Fig. 9E) is different from the vertical arrangement since it is based on an "interdigitated" circuit as shown in Fig. 1B.

While the invention has been described with respect to a limited number of embodiments, those skilled in the art, having benefit of this disclosure, will appreciate that other embodiments can be devised which do not depart from the spirit of the invention as disclosed herein. Accordingly, the scope of the invention should be limited only by the attached claims.

REFERENCES

Ref. 1 : C-X. Shi et al., IEEE Trans. Electron. Dev. 39(5) 1028 (1992)
Ref. 2 : M.I. Ito et al., Contacts, IEEE J. Quant. Elec. QE-22(7), 1073 (1986).
Ref. 3 : R.B. Darling et al., J. App. Phys. 67 3152 (1990)
Ref. 4 : H.S. Fresser et al., J. Vac. Sci. Technol. B 13(6) 2553 (1995)
Ref. 5 : US 5,780,916
Ref. 6 : N. Newman et al., J. Vac. Sci. Technol. B 4(4) 931 (1986)

**Claims**

1. A photodetector configured to detect incident light in a given range of wavelengths comprising:

   an absorbing semiconductor layer (325) configured to absorb light within said given range of wavelengths;
   a first semiconductor layer (321) made of a first semiconductor material and in electrical contact with said absorbing semiconductor layer;
   a first metal electrode (340) configured to be electrically connected to a negative pole of a voltage generator, wherein the first metal electrode (340) is in electrical contact with the first semiconductor layer (321), the first semiconductor layer (321) is arranged between said first metal electrode (340) and the absorbing semiconductor layer (325) and wherein the first metal electrode (340) and the first semiconductor layer (321) are configured to produce an electron Schottky junction under application of a bias voltage;
   a second semiconductor layer (322) made of a second semiconductor material different from the first semiconductor material, in electrical contact with said absorbing semiconductor layer;
   a second metal electrode (330) configured to be electrically connected to a , positive pole of said voltage generator, wherein the second metal electrode (340) is in electrical contact with the second semiconductor layer, the second semiconductor layer (322) is arranged between said second metal electrode (330) and the absorbing semiconductor layer (325) and wherein the second metal electrode (330) and the second semiconductor layer (322) are configured to produce a hole Schottky junction under application of a bias voltage.

2. The photodetector according to claim 1, wherein the absorbing semiconductor layer (325) comprises a semiconductor material chosen among: germanium, a III-V compound or a II-VI compound.

3. The photodetector according to claim 1, wherein the absorbing semiconductor layer (325) comprises silicon.

4. The photodetector according to any of the preceding claims, wherein the first metal electrode (340) is arranged on a first side of the absorbing semiconductor layer (325) and the second metal electrode (330) is arranged on a second side of the absorbing semiconductor layer, opposite to the first side.

5. The photodetector according to claim 4, further comprising a first graded semiconductor heterostructure (326) in contact with a surface of the absorbing semiconductor layer (325) and a surface of the first semiconductor layer (321).

6. The photodetector according to any of claims 4 or 5, further comprising a second graded semiconductor heterostructure (327) in contact with a surface of the absorbing semiconductor layer and a surface of the second semiconductor layer (322).

7. The photodetector according to any of the claims 1 to 3, wherein said first metal electrode (340) and said second metal electrode (330) are arranged on a same side of the absorbing semiconductor layer (325).

8. The photodetector according to claim 5, further comprising a first graded semiconductor heterostructure (326) in contact with a surface of the absorbing semiconductor layer (325) and a surface of the first semiconductor layer (321) or a second graded semiconductor heterostructure (327) in contact with a surface of the absorbing semiconductor layer and a surface of the second semiconductor layer (322).

9. The photodetector according to any of claims 7 or 8, further comprising a third graded semiconductor heterostructure in contact with a surface of the first semiconductor layer (321) and a surface of the second semiconductor layer (322).

10. The photodetector according to any of the preceding claims, wherein the electron Schottky junction has an electron Schottky barrier ($\phi_e$) seen by the electrons greater than half the bandgap of the first semiconductor material and the hole Schottky junction has a hole Schottky barrier ($\phi_h$) seen by the holes greater than half the bandgap of the second semiconductor material.

11. The photodetector according to any of the preceding claims, further comprising an interfacial layer in contact with a surface of said first semiconductor layer (321) and a surface of said first metal electrode (340) and/or an interfacial layer in contact with a surface of said second semiconductor layer (322) and a surface of said second metal electrode (330).

12. A photodetection circuit comprising:

   a photodetector according to any of the preceding claims;
   a voltage generator, wherein the first metal electrode (340) is electrically connected to a negative pole of the voltage generator and the second metal electrode (330) is electrically connected to a positive pole of the voltage generator.

13. A method for fabricating a photodetector according to claim 1, the method comprising:

   depositing on a substrate (901) a semiconductor stack (320) comprising the absorbing semiconductor layer (325), the first semiconductor layer (321), the second semiconductor layer (322);
   depositing on the semiconductor stack (320) a metal layer to make the first metal electrode;
   flipping the substrate (901) together with the semiconductor stack (320) and pasting on a host substrate (905);
   etching the substrate (901) and depositing a metal layer to make the second electrode (330).

14. The method according to claim 13, wherein the semiconductor stack (320) further comprises a first graded semiconductor heterostructure (326) in contact with a surface of the absorbing semiconductor layer (325) and a surface of the first semiconductor layer (321) and/or a second graded semiconductor heterostructure (327) in contact with a surface of the absorbing semiconductor layer and a surface of the second semiconductor layer.

FIG.1A (PRIOR ART)

FIG.1B (PRIOR ART)

EP 4 456 155 A1

V = 0

$E_C$

10

11

$E_F$

12

$E$

x

$E_V$

V ≠ 0

11 $\varphi_e$

$E_F$

$E_C$

10

V

12

$\varphi_h$

$E_V$

FIG.2A (PRIOR ART)

V = 0

$E_C$

10

11

$E_F$

12

$E$

x

$E_V$

V ≠ 0

11 $\varphi_e$

$E_F$

$E_C$

10

V

12

$\varphi_h$

$E_V$

FIG.2B (PRIOR ART)

FIG.3A

FIG.3B

FIG.4A

FIG.4B

EP 4 456 155 A1

330

| Hole Schottky semiconductor | 322 |
| Graded semiconductor | 327 |
| Absorbing semiconductor | 325 |
| Graded semiconductor | 326 |
| Electron Schottky semiconductor | 321 |

320

340

310

20

V

+

−

FIG.5A

FIG.5B

340

321

320 { Electron Schottky semiconductor

Hole Schottky semiconductor

20

Graded semiconductor

Absorbing semiconductor

330

322

327

325

310

FIG.6A

FIG.6B

FIG.7A

EP 4 456 155 A1

FIG.7B

FIG.8

FIG.9A

340
320
901

FIG.9B

901
320
340

906
905

FIG.9C

FIG.9D

FIG.9E

Europäisches
Patentamt

European
Patent Office

Office européen
des brevets

# EUROPEAN SEARCH REPORT

Application Number

EP 23 31 5119

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2020/028000 A1 (WANG SHIH-YUAN [US] ET AL) 23 January 2020 (2020-01-23)<br>* paragraph [0331] - paragraph [0334]; figures 10, 11A * | 1-9, 11-14<br>10 | INV.<br>H01L31/108 |
| X<br>A | US 9 431 557 B2 (KNIGGE ANDREA [DE]; WEYERS MARKUS [DE] ET AL.) 30 August 2016 (2016-08-30)<br>* the whole document * | 1-9, 11-14<br>10 | |
| X | KIM J ET AL: "IMPROVEMENT OF DARK CURRENT USING INP/INGAASP TRANSITION LAYER IN LARGE-AREA INGAAS MSM PHOTODETECTORS", IEEE TRANSACTIONS ON ELECTRON DEVICES, IEEE, USA, vol. 51, no. 3, 1 March 2004 (2004-03-01), pages 351-356, XP001190237, ISSN: 0018-9383, DOI: 10.1109/TED.2003.822276 | 1-9, 11-14 | |
| A | * the whole document * | 10 | TECHNICAL FIELDS SEARCHED (IPC) |
| A | KR 101 848 011 B1 (GENICOM CO LTD [KR]) 28 May 2018 (2018-05-28) * the whole document * | 1-14 | H01L |

The present search report has been drawn up for all claims

| Place of search | Date of completion of the search | Examiner |
|---|---|---|
| Berlin | 7 September 2023 | Voignier, Vincent |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
......................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 31 5119

This annex lists the patent family members relating to the patent documents cited in the above-mentioned European search report.
The members are as contained in the European Patent Office EDP file on
The European Patent Office is in no way liable for these particulars which are merely given for the purpose of information.

07-09-2023

| Patent document cited in search report | | Publication date | Patent family member(s) | | Publication date |
|---|---|---|---|---|---|
| US 2020028000 | A1 | 23-01-2020 | NONE | | |
| US 9431557 | B2 | 30-08-2016 | DE 102011075103 | A1 | 08-11-2012 |
| | | | EP 2705541 | A2 | 12-03-2014 |
| | | | US 2014070272 | A1 | 13-03-2014 |
| | | | WO 2012150177 | A2 | 08-11-2012 |
| KR 101848011 | B1 | 28-05-2018 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5780916 A

**Non-patent literature cited in the description**

- **C-X. SHI et al.** *IEEE Trans. Electron. Dev.,* 1992, vol. 39 (5), 1028
- **M.I. ITO et al.** Contacts. *IEEE J. Quant. Elec.,* 1986, vol. QE-22 (7), 1073
- **R.B. DARLING et al.** *J. App. Phys.,* 1990, vol. 67, 3152
- **H.S. FRESSER et al.** *J. Vac. Sci. Technol. B,* 1995, vol. 13 (6), 2553
- **N. NEWMAN et al.** *J. Vac. Sci. Technol. B,* 1986, vol. 4 (4), 931